# EUROPÄISCHE PATENTSCHRIFT

(11) **EP 2 536 865 B1**
(45) Veröffentlichungstag und Bekanntmachung des Hinweises auf die Patenterteilung: **22.07.2015**
(21) Anmeldenummer: 11706191.1
(22) Anmeldetag: 08.02.2011
(51) Int. Cl.: C23C 14/54, C23C 16/46

(54) **BESCHICHTUNGSVORRICHTUNG SOWIE VERFAHREN ZUM BETRIEB EINER BESCHICHTUNGSVORRICHTUNG MIT EINER SCHIRMPLATTE**
COATING DEVICE, AND METHOD FOR OPERATING A COATING DEVICE WITH A SHIELDING PLATE
DISPOSITIF DE REVÊTEMENT AINSI QUE PROCÉDÉ POUR LE FONCTIONNEMENT D'UN DISPOSITIF DE REVÊTEMENT DOTÉ D'UNE PLAQUE DE PROTECTION

(30) Priorität: 17.02.2010 DE 102010000447
(43) Veröffentlichungstag der Anmeldung: 26.12.2012
(73) Patentinhaber: Aixtron SE, 52134 Herzogenrath (DE)
(72) Erfinder: STRAUCH, Gerhard Karl, 52072 Aachen (DE); FRANKEN, Walter, 52249 Eschweiler (DE); KOLLBERG, Marcel, 52146 Würselen (DE); KITTEL, Florenz, 52134 Aachen (DE); GERSDORFF, Markus, 52134 Herzogenrath (DE); KÄPPELER, Johannes, 52146 Würselen (DE)
(74) Vertreter: Grundmann, Dirk
(86) Internationale Anmeldenummer: PCT/EP2011/051793
(87) Internationale Veröffentlichungsnummer: WO 2011/101273

(56) Entgegenhaltungen:
- EP-A1- 1 167 566
- DE-A1-102009 003 781
- US-B1- 6 462 310

## Beschreibung

Die Erfindung betrifft eine Vorrichtung zum Beschichten eines Substrates mit einer Prozesskammer, in welcher sich ein temperierbares Gaseinlassorgan zum Einleiten eines Ausgangsstoffs zusammen mit einem Trägergas und ein Suszeptor zur Aufnahme des Substrates befinden, mit einer mit der Prozesskammer über eine Beladeöffnung verbundenen Substratbevorratungskammer zur Bevorratung eines Substrates, mit einer Fördereinrichtung zum Be- und Entladen der Prozesskammer mit Substraten.

Die Erfindung betrifft darüber hinaus ein Verfahren zum Betrieb einer derartigen Vorrichtung.

Die DE 101 59 702 A1 beschreibt eine Vorrichtung bestehend aus einer ein Gaseinlassorgan und einen Suszeptor aufweisende Prozesskammer, die mit einem Greifarm mit Substraten beladbar ist, die vom Greifarm einer Substratbevorrätungskammer entnommen werden. Innerhalb der Prozesskammer findet ein Beschichtungsprozess statt. Hierzu werden gasförmige Ausgangsstoffe mit Hilfe eines Trägergases durch das Gaseinlassorgan in die Prozesskammer gebracht. Auf der Substratoberfläche wird eine dünne Schicht abgeschieden.

Es kann sich dabei um ein chemisches oder um ein physikalisches Beschichtungsverfahren handeln. Die DE 10 2008 026 974 A1 beschreibt beispielsweise eine Vorrichtung mit einem Verdampfer zum Verdampfen eines festen oder flüssigen Ausgangsstoffes. Der verdampfte Ausgangsstoff wird mit einem Trägergas über eine Trägergasleitung in eine Pyrolysekammer gebracht. Bei dem Ausgangsstoff kann es sich um polymeres Paraxylylene handeln. Das verdampfte Dimer wird in der Pyrolysekammer in ein Monomer zerlegt. Das Monomer wird zusammen mit dem Trägergas in das Gaseinlassorgan gebracht. Das Gaseinlassorgan befindet sich in einer gasdicht nach außen verschlossenen Prozesskammer und besitzt eine Gasaustrittsfläche mit einer Vielzahl siebartig angeordneter Öffnungen, durch die das den Ausgangsstoff transportierende Trägergas in die Prozesskammer einströmt. Das Gaseinlassorgan ist temperiert. Dort ist das Gaseinlassorgan beheizt. Unterhalb des Gaseinlassorganes befindet sich ein gekühlter Suszeptor. Auf der gekühlten Substratauflagefläche des Suszeptors ist ein Substrat, beispielsweise eine Glasplatte auflegbar. Das Substrat wird mit einer Polymerschicht beschichtet, indem das gasförmig in die Prozesskammer gebrachte Polymer dort kondensiert.

In der DE 10 2008 037 387 wird eine Maskenanordnung beschrieben. Die dort beschriebene Schattenmaske wird auf die Oberfläche eines zu beschichtenden Substrates aufgelegt, um es strukturiert zu beschichten.

Die DE 102 32 731 A1 beschreibt eine Beschichtungseinrichtung, mit der Halbleiterschichten aus Elementen der Gruppe IV, III-IV, II-VI sowie von organischen Stoffen abgeschieden werden können.

Der Erfindung liegt die Aufgabe zugrunde, eine gattungsgemäße Vorrichtung effizienter auszugestalten.

Gelöst wird die Aufgabe durch die in den Ansprüchen angegebene Erfindung, wobei jeder Anspruch eine eigenständige Lösung der Aufgabe darstellt und mit jedem anderen Anspruch kombinierbar ist.

Die erfindungsgemäße Vorrichtung eignet sich besonders zum Abscheiden von Paraxylylenen oder auch mehrkomponentiger Schichten, beispielsweise OLEDs oder auch Halbleiterschichten. Die Ausgangsstoffe werden in einem außerhalb der Prozesskammer angeordneten Gasmischsystem bzw. einer Gasvorbereitungseinrichtung vorbereitet und gelangen durch eine insbesondere temperierte Zuleitung in das beheizte Gaseinlassorgan. Letzteres besitzt einen Hohlkörper mit zumindest einer Kammer, in die das den Ausgangsstoff fördernde Trägergas eingeleitet wird. Das Gaseinlassorgan hat eine Gasaustrittsfläche, die einen kreisrunden, bevorzugt jedoch einen rechteckigen, insbesondere quadratischen Grundriss aufweist. Der Grundriss entspricht im wesentlichen der Fläche des Substrates. In der Gasaustrittsfläche befinden sich eine Vielzahl von siebartig angeordneten Gasaustrittsöffnungen, durch die das Prozessgas in die Prozesskammer strömt, deren Boden von einem Suszeptor ausgebildet wird. Dieses, die Form eines Duschkopfes aufweisende Gaseinlassorgan wird auf Temperaturen von 200° C bis 400° C geheizt. Die Prozesskammer wird mittels einer Vakuumeinrichtung in einem Druckbereich zwischen 0,1 mbar und 2 mbar betrieben. Bei dem Suszeptor handelt es sich um einen gekühlten Körper mit einer Substratauflagefläche. Die Auflagefläche ist so gewählt, dass ein Wärmeabtransport vom Substrat hin zum Suszeptor erfolgen kann. Dieser wird auf Temperaturen zwischen -30° C und 80° C temperiert. Der Beschichtungsprozess findet bei einem aktiv gekühlten Substrat statt, so dass sich die Ausgangsstoffe dort bei den niedrigen Temperaturen abscheiden können. Bei dem erfindungsgemäßen Verfahren ist vorgesehen, dass die Beladung und die Entladung der Prozesskammer bei beheiztem Gaseinlassorgan stattfindet. Um zu vermeiden, dass sich das Substrat vor der Ablage auf dem Suszeptor aufheizt, wird vor dem Beladen bzw. dem Entladen eine Schirmplatten zwischen Gaseinlassorgan und Suszeptor gebracht. Die Schirmplatte kann alternativ auch dazu verwendet werden, eine Maske, die zur Strukturierung der abzuscheidenden Schicht auf das Substrat gelegt wird, gegen Aufheizen zu schützen. Die Schirmplatte befindet sich unmittelbar unterhalb der Gasaustrittsfläche des Gaseinlassorgans. Die Schirmplatte hat eine hoch reflektierende Oberfläche, so dass das Substrat bzw. die Maske gegenüber Strahlung vom Gaseinlassorgan abgeschirmt wird. Die Schirmplatte kann beidseitig hoch reflektierend beschichtet sein. Bevorzugt besteht die Schirmplatte aus zwei parallel sich zueinander erstreckenden Glas- bzw. Quarzplatten, zwischen denen eine dünne Metallfolie liegt. Es kann sich um eine 100µm dicke Folie handeln, die aus INVAR, Gold oder Aluminium besteht. Die Folie ist schwimmend zwischen Glasplatte und Quarzglasplatte gelagert. Die Folie besitzt eine Emissivität ε < 0,1. Um die Schirmplatte während des Beschichtungsprozesses außerhalb der Prozesskammer aufzubewahren, ist eine weitere Bevorratungskammer vorgesehen, in welcher die Schirmplatte Aufnahme findet. Bei dieser Bevorratungskammer kann es sich um eine Maskenbevorratungskammer handeln, in der mindestens eine Maske bevorratet wird, die zum strukturierten Beschichten der Substratoberfläche auf die Substratoberfläche aufgebracht wird. In einer bevorzugten Ausgestaltung der Erfindung ist die Schirmplatte das Transportorgan, um die Maske aus der Maskenbevorratungskammer in die Prozesskammer zu bringen. Hierzu besitzt die Schirmplatte Halterungsmittel. Die Halterungsmittel können an der Unterseite der Schirmplatte angeordnet sein und formschlüssig in entsprechende Gegenhalterungsmittel der Maske eingreifen. Mit Hilfe der Schirmplatte kann die Maske aus einem Maskenmagazin der Maskenbevorratungskammer entnommen werden. Dabei wird die Maske während des Maskentransfers mit Hilfe der Schirmplatte gegenüber dem beheizten Gaseinlassorgan abgeschirmt. Hierdurch ist die Maske gegen eine Temperaturerhöhung geschützt. Mit der Schirmplatte kann also nicht nur das Substrat, sondern auch die Maske gegen eine Temperaturerhöhung geschützt werden. Das Maskenmagazin kann vertikal ähnlich einem Aufzug innerhalb der Bevorratungskammer verlagert werden. In dem Magazin können in vertikal übereinander liegenden Etagen verschiedenartig gestaltete Masken bevorratet werden. Dieses Magazin besitzt auch ein Fach, in welches die Schirmplatte einfahren kann. Bevorzugt kann die Schirmplatte in jedes der Magazinfächer des Magazins einfahren, in dem auch eine Maske Aufnahme findet. Innerhalb der Magazinbevorratungskainmer kann eine Schirmplattenverlagerungseinrichtung angeordnet sein. Es kann sich dabei um ein Schienensystem handeln. Das Schienensystem kann zwei Schienenpaare besitzen, wobei ein Schienenpaar in dem Magazin und ein zweites Schienenpaar in der Prozesskammer angeordnet ist. Die Schirmplatte kann eine Rollenführung besitzen, mit der sie auf dem Schienenpaar geführt wird. Der horizontale Verlagerungsantrieb, um die Schirmplatte zwischen ihrer Abschirmstellung unterhalb des Gaseinlassorganes und ihrer Bevorratungsstellung innerhalb des Magazins zu verlagern, kann ein Pneumatikantrieb oder ein elektrischer Linearantrieb sein. Es kann sich hier auch um einen Spindel antrieb handeln. Die Substratbevorratungskammer kann ebenfalls ein Magazin aufweisen, in dem in vertikal übereinander angeordneten Etagen verschiedene Substrate angeordnet sind. Die Substrate können auf insbesondere gabelförmigen Substrathalterungen liegen, die auch dazu benutzt werden, um das Substrat in die Prozesskammer zu bringen. Beide Bevorratungskammern sind jeweils mittels gasdicht verschließbaren Be-/Entladeöffnungen mit der Prozesskammer verbunden. Die Beladeöffnungen können mit gasdichten Toren verschlossen werden. Sowohl die Maskenbevorratungkammer als auch die Substratbevorratungskammer können mit Hilfe einer Vakuumeinrichtung evakuiert werden. Zur Entnahme der Substrate aus der Gesamtvorrichtung kann die Substratbevorratungskammer auf Atmosphärendruck gebracht werden. Der Suszeptor kann wassergekühlt sein. Der Suszeptor kann in Vertikalrichtung verlagerbar sein. In der Be-/Entladestellung hat der Suszeptor eine abgesenkte Position. In dieser Stellung ragen aus der Substratauflagefläche des Suszeptors Stützstifte. Auf diese Stützstifte kann mittels einer Fördereinrichtung, bspw. der gabelförmigen Substrathalterung ein Substrat abgelegt werden. Dies erfolgt durch die Beladeöffnung hindurch. Zuvor wurde mit Hilfe der oben geschilderten Schirmplattenverlagerung die Schirmplatte unter das beheizte Gaseinlassorgan gebracht. Durch Anheben des Suszeptors tritt dieser in Flächenkontakt mit der Unterseite des Substrates. Es ist aber auch möglich, mit Hilfe versenkbarer Stützstifte das Substrat auf einem ortsfesten Suszeptor abzulegen.

Bei dem erfindungsgemäßen Verfahren erfolgt das Be- und Entladen der Prozesskammer mit einem oder mehreren Substraten bei aufgeheiztem Gaseinlassorgan und gekühltem Suszeptor. Während der Be-/Entladephase tritt lediglich ein Trägergas durch das Gaseinlassorgan in die Prozesskammer. Zu Beginn ist der unbeladene Suszeptor in seiner maximalen Entfernung vom Gaseinlassorgan. Das Beladetor zur Maskenbevorratungskammer wird geöffnet. Mit Hilfe der Schirmplattenverlagerungseinrichtung wird die Schirmplatte in die Prozesskammer hineinverlagert und unterhalb des Gaseinlassorganes derart positioniert, dass es die vom Gaseinlassorgan abgestrahlte Wärmestrahlung reflektiert. Die Schirmplatte hat eine isolierende Wirkung. Mit ihr wird der Wärmezufluss vom Gaseinlassorgan zum Substrat unterbrochen, zumindest aber gehemmt. Sodann wird das Magazin in eine Vertikalposition gebracht, in der eine zu verwendende Maske unmittelbar vor der Beladeöffnung liegt. Mit Hilfe der Schirmplattenverlagerungseinrichtung wird die Schirmplatte zurück in das Magazin gefahren und zwar unmittelbar über die zu verwendende Maske bzw. den die Maske haltenden Maskenrahmen. Mit einer Halteeinrichtung wird der Maskenrahmen bzw. die Maske an der Unterseite der Schirmplatte befestigt und von der Schirmplatte in die Prozesskammer gebracht. Im Anschluss daran wird die Beladeöffnung zur Substratbevorratungskammer geöffnet und mit Hilfe einer Fördereinrichtung ein Substrat auf die oben bereits erwähnten Stifte gebracht. Das Substrat befindet sich jetzt zwischen Suszeptor und Schirmplatte. Zufolge der reflektierenden bzw. isolierenden Wirkung der Schirmplatte kommt es zu keiner schädlichen Aufwärmung des Substrates infolge der vom Gaseinlassorgan abgegebenen Wärme. Durch Absenken der Stifte bzw. Anheben des Suszeptors wird das Substrat auf der Substratablagefläche des Suszeptors abgelegt, so dass es vom Suszeptor gekühlt wird. Die Maske wird dann entweder durch eine Aufwärtsverlagerung des Suszeptors oder durch eine Abwärtsverlagerung der Schirmplatte auf das Substrat gelegt. Anschließend wird die Schirmplatte wieder zurück in das Magazin der Maskenbevorratungskammer verfahren. Nachdem die Tore der Beladeöffnungen gasdicht verschlossen worden sind, wird das Prozessgas in die Prozesskammer eingeleitet, so dass eine Schicht auf dem Substrat abgeschieden werden kann. Vor dem Ablegen des Substrats auf den Suszeptor kann der Suszeptor zusammen mit dem Substrat und der Maske auch gemeinsam abgesenkt werden. Beim Absenken des Suszeptors ist die Maske nicht in Kontakt mit dem Suszeptor.

Als Ausgangsstoff können die oben genannten organischen oder anorganischen Verbindungen verwendet werden. Bevorzugt wird mittels der Vorrichtung Paraxylylene auf einem Substrat abgeschieden. Es können aber OLED-Schichten abgeschieden werden. Grundsätzlich ist die Vorrichtung auch für eine MOCVD geeignet.

Ein Ausführungsbeispiel der Erfindung wird nachfolgend anhand beigefügter Zeichnungen erläutert. Es zeigen:
- Fig.1: schematisch in Form eines Vertikalschnitts die wesentlichen Elemente einer Vorrichtung bestehend aus einer Prozesskammer 1, einer Maskenbevorratungskammer 2 und einer Substratbevorratungskammer 3 in einer Ausgangsstellung mit geschlossenen Beladetoren 8 und leerer Prozesskammer 1;
- Fig. 2: eine Darstellung gemäß Fig. 1, wobei aus einem Magazin 9 der Maskenbevorratungskammer 2 eine Schirmplatte 11 durch eine Beladeöffnung 6 in die Prozesskammer 1 transportiert wird;
- Fig. 3: eine Folgedarstellung zu Fig. 2, in welcher sich die Schirmplatte 11 unterhalb eines Gaseinlassorganes 4 befindet und das Magazin 9 in Richtung des Pfeiles P₂ abgesenkt worden ist, so dass eine Maske 10 vor der Beladeöffnung 6 liegt;

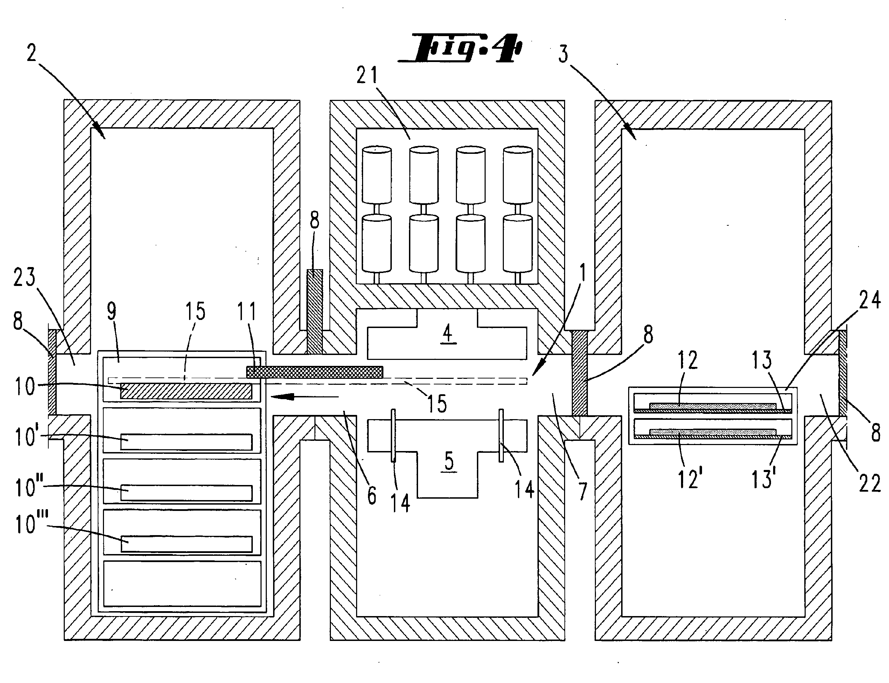

- Fig. 4: eine Folgedarstellung zu Fig. 3, wobei die Schirmplatte 11 durch die Beladeöffnung 6 in Richtung oberhalb der vor der Beladeöffnung 6 liegenden Maske 10 gebracht wird;
- Fig. 5: eine Folgedarstellung zu Fig. 4, wobei die Maske 10 mittels Halterungen unterhalb der Schirmplatte 11 befestigt ist;
- Fig. 6: eine Folgedarstellung zu Fig. 5, wobei die Maske 10 zusammen mit der Schirmplatte 11 durch die Beladeöffnung 6 in die Prozesskammer 1 transportiert wird;
- Fig. 7: eine Folgedarstellung zu Fig. 6, wobei die Schirmplatte 11 zusammen mit der von ihr getragenen Maske 10 unterhalb des Gaseinlassorganes 4 positioniert ist;
- Fig. 8: eine Folgedarstellung zu Fig. 7, wobei das Tor der Beladeöffnung 6 geschlossen, das Tor 8 der Beladeöffnung 7 geöffnet und mittels eines Substrathalters 13 ein zu beschichtendes Substrat 12 in die Prozesskammer 1 in eine Position oberhalb eines Suszeptors 5 und unterhalb der Maske 10 gebracht worden ist;
- Fig. 9: eine Folgedarstellung zu Fig. 8, wobei die Maske 10 auf das auf Stützstiften 14 ruhende Substrat 12 abgesenkt und der Substrathalter 13 aus der Prozesskammer 1 in die Substratbevorratungskammer 3 wieder zurückgezogen worden ist;
- Fig. 10: eine Folgedarstellung zu Fig. 9, wobei das Substrat nach Hochfahren des Suszeptors 5 auf dessen Oberseite liegt;
- Fig. 11: eine Folgedarstellung zu Fig. 10, wobei die Schirmplatte 11 aus der Prozesskammer 1 in das Magazin 9 verlagert worden ist, so dass der Beschichtungsprozess stattfinden kann;
- Fig. 12: eine schematische Schnittdarstellung gemäß der Linie XII - XII in Fig. 1;
- Fig. 13: das Querschnittsprofil der Schirmplatte 11 und
- Fig. 14: schematisch einen Querschnitt durch die Prozesskammer zur Verdeutlichung der Fördereinrichtungen für die Schirmplatte 11 und das Substrat 12.

Die in den Zeichnungen dargestellte Vorrichtung besteht aus einer gasdicht gegenüber der Umgebung abgeschlossenen Prozesskammer 1, einer oberhalb der Prozesskammer 1 angeordneten Gasversorgungseinrichtung 21, und einem in der Prozesskammer 1 angeordneten Gaseinlassorgan 4 mit Prozessgasen, die mittels Trägergasen dorthin transportiert werden können, versorgt wird. Mittels einer nicht dargestellten Vakuumpumpe kann die Prozesskammer 1 evakuiert werden.

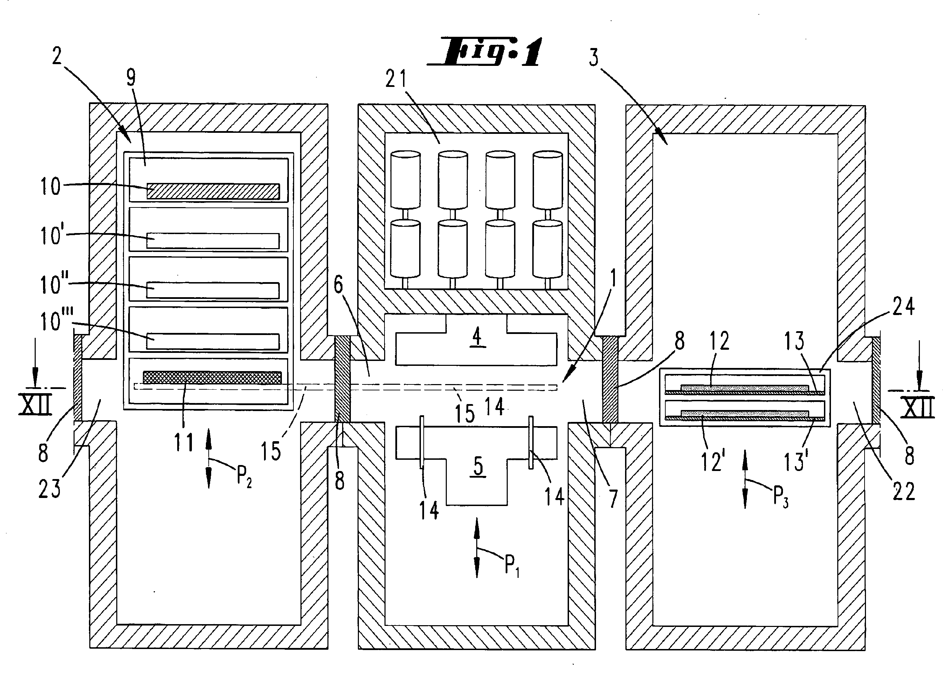

Die Figur 1 zeigt rechts neben der Prozesskammer 1 eine Substratbevorratungskammer 3, die mit einer von einem Tor 8 verschließbaren Beladeöffnung 7 mit der Prozesskammer 1 verbunden ist. Innerhalb der Substratbevorratungskammer 3 befindet sich ein Magazin 24, welches in Richtung des Doppelpfeiles P₃ vertikal verlagert werden kann. Das in den Zeichnungen dargestellte Magazin 24 besitzt zwei Etage, wobei in jeder der beiden Etagen ein Substrathalter 13,13' liegt, der auch die Funktion einer Substratfördereinrichtung ausübt. Auf den Substrathaltern 13, 13' liegt jeweils ein großflächiges Substrat 12, 12'. In einem nicht dargestellten Ausführungsbeispiel hat das Magazin 24 mehr Etagen und kann somit mehr Substrate 12, 12' bevorraten. Die Magazinplätze des Magazins 24 können durch die Beladeöffnung 22, die ebenfalls von einem Tor 8 verschlossen ist, beladen bzw. entladen werden. Die Substratbevorratungskammer 3 kann ebenfalls von einer Vakuumeinrichtung evakuiert werden. In die Bevorratungskammer 3 mündet zu dem eine nicht dargestellte Gaszuleitung, um die Bevorratungskammer 3 mit einem Inertgas auf Atmosphärendruck zu fluten, damit der Beladungsprozess durch die Beladeöffnung 22 vorgenommen werden kann.

In der Figur 1 ist links neben der Prozesskammer 1 eine Maskenbevorratungskammer 2 dargestellt. Ebenso wie die Substratbevorratungskammer 3 besitzt die Maskenbevorratungskammer 2 ein gasdichtes Gehäuse und kann mittels einer nicht dargestellten Vakuumeinrichtung evakuiert werden. Auch hier ist eine Gasversorgung vorgesehen, um die Maskenbevorratungskammer 2 mit einem Inertgas zu fluten. In der Maskenbevorratungskammer 2 befindet sich ein aufzugartig in Richtung des Doppelpfeiles P₂ verlagerbares Magazin 9 mit einer Vielzahl von Magazinplätzen. Diese, etagenartig übereinander angeordnete Magazinplätze sind mit Masken 10, 10',10", 10"' bestückbar. Die Masken 10, 10', 10", 10'" sind an nicht dargestellten Halterungen befestigt, um, wie weiter unten noch im Detail beschrieben wird, von einer in der untersten Etage angeordneten Schirmplatte 11 in die Prozesskammer 1 durch die Beladeöffnung 6 transportiert werden zu können, mit der die Maskenbevorratungskammer 2 mit der Prozesskammer 1 verbunden ist und die der Beladeöffnung 7 gegenüberliegt. Auf der zur Beladeöffnung 6, die mit einem gasdichten Tor 8 verschließbar ist, gegenüberliegenden Seite befindet sich eine Beladeöffnung 23, die ebenfalls von einem Tor 8 gasdicht verschließbar ist. An diese Beladeöffnung 23 schließt sich eine nicht dargestellte weitere Maskenbevorratungskammer 2 an, die weitere Masken ebenfalls in einem vertikal verlagerbaren Magazin 9 bevorratet. Durch die Beladeöffnung 23 können Masken zwischen den beiden Maskenbevorratungskammern 2 ausgetauscht werden.

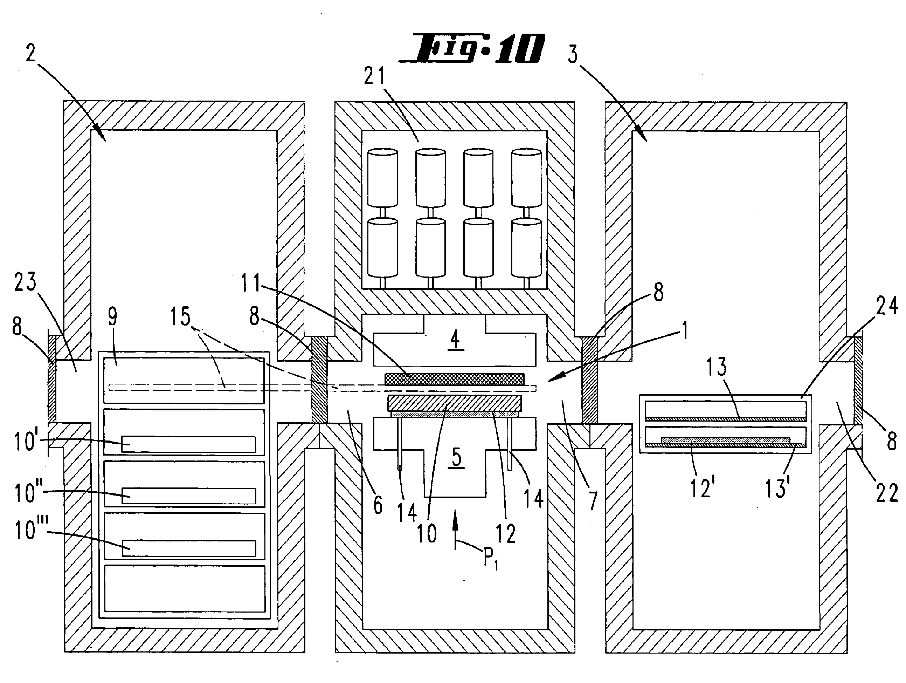

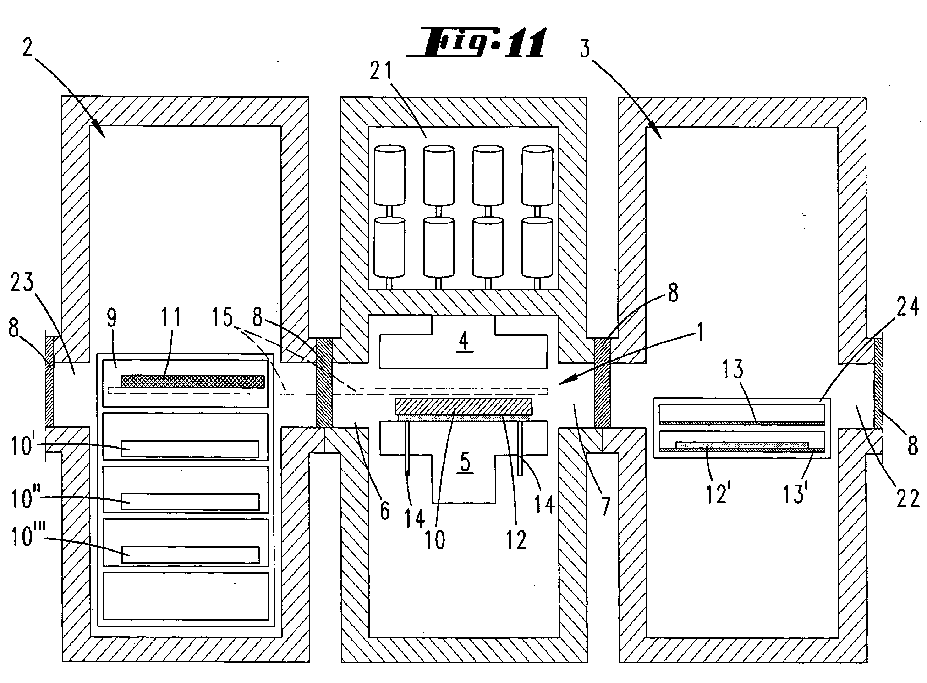

Die Figur 11 zeigt schematisch einen Vertikalschnitt durch die Vorrichtung im Bereich der Prozesskammer. In der auf der rechten Seite dargestellten Substratbevorratungskammer 3 befindet sich das Magazin 24, welches aus einem Gestell mit einer Vielzahl von Etagen besteht. Jede Etage trägt einen gabelförmigen Substrathalter 13, mit dem das auf ihm aufliegende Substrat 12 nach links, durch die geöffnete Beladeöffnung 7 in die Prozesskammer 1 bringbar ist. In dieser befindet sich unterhalb des Gaseinlassorganes 4 ein einen rechteckigen Grundriss aufweisender Suszeptor 5, der in Richtung des in Figur 1 gezeigten Doppelpfeiles P₁ vertikal verlagerbar ist. In Vertikalöffnungen des Suszeptors 5 befinden sich Stützstifte 14, die in der abgesenkten Stellung des Suszeptors 5 über die Oberfläche des Suszeptors ragen und auf die das Substrat 12 abgelegt werden kann. Durch Hochfahren des Suszeptors 5 bis in die in Figur 10 bzw. 11 dargestellte Stellung kann das Substrat 12 auf die zum Gaseinlassorgan 4 weisende Oberseite des Suszeptors 5 aufgelegt werden.

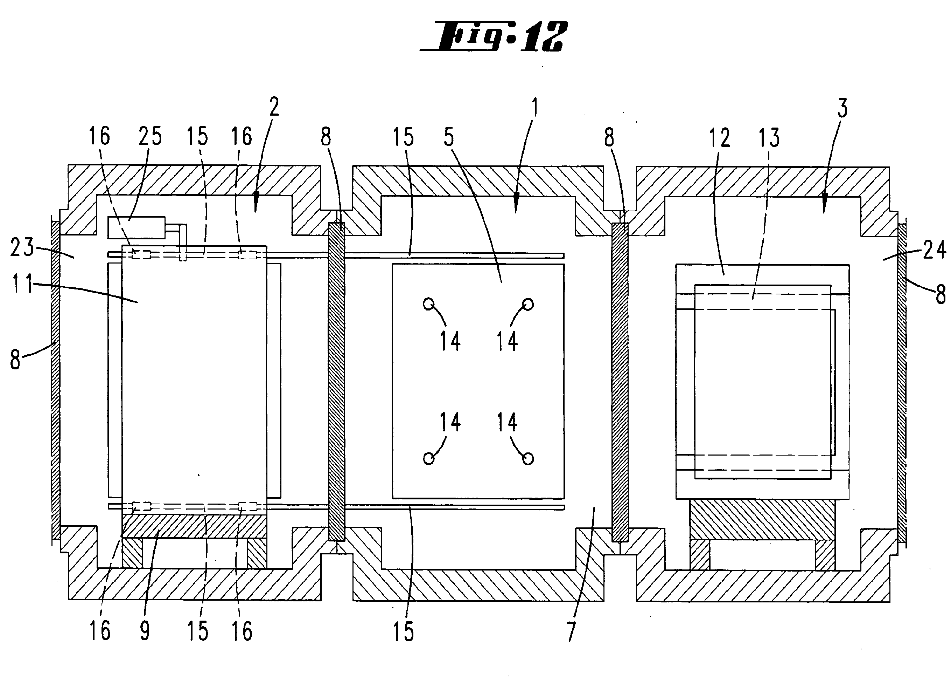

In der Figur 12 sind ferner die in der Figur 1 nur gestrichelt dargestellten Schienen 15 dargestellt, auf denen die Schirmplatte 11 mit Hilfe von der Schirmplatte 11 zugeordneten Rollen 16 verfahren werden kann. Es sind insgesamt zwei Schienenpaare 15 vorgesehen. Ein Schienenpaar 15 befindet sich in der Prozesskammer 1 etwas unterhalb der Höhe des Gaseinlassorganes 4. Ein anderes Schienenpaar ist innerhalb des Magazins 9 bzw. innerhalb der Maskenbevorratungskammer 2 so angeordnet, dass es mit dem in der Prozesskammer 1 angeordneten Schienenpaar 15 zumindest in einer Beladestellung fluchtet. Auf den Schienen 15 kann die Schirmplatte 11 in Horizontalrichtung verlagert werden. Hierzu ist eine Antriebsvorrichtung 25 vorgesehen, die beispielsweise mit Pneumatikzylindern, Hydraulikzylindern oder mit einem Spindelantrieb an der Schirmplatte 11 angreift.

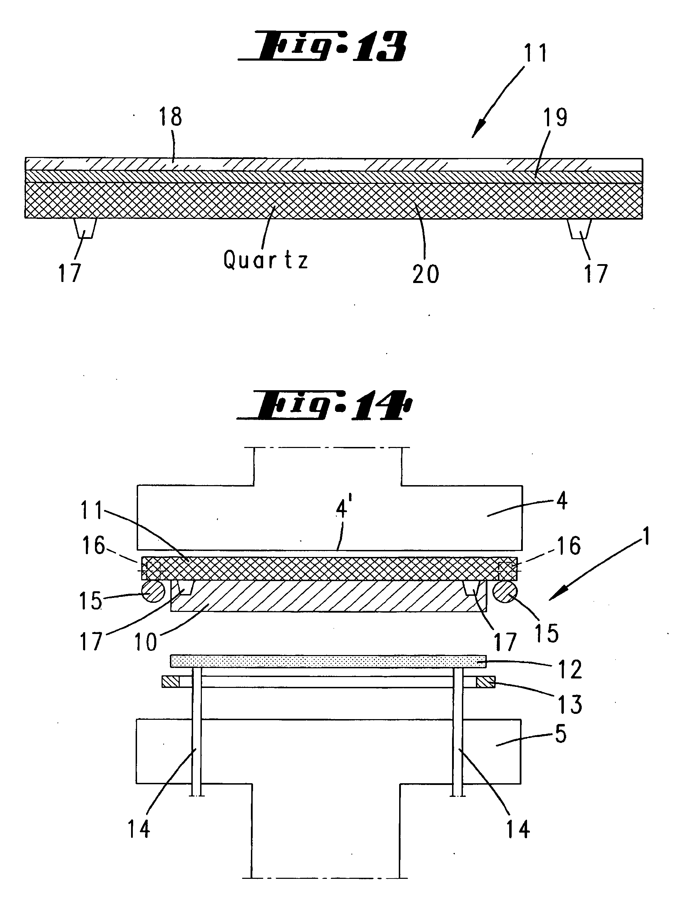

Die Figur 14 zeigt schematisch den Querschnitt durch die Prozesskammer. Die Decke der Prozesskammer 1 wird von der Unterseite 4' eines Gaseinlassorganes 4 ausgebildet. Die Unterseite 4' besitzt eine Vielzahl von nicht dargestellten Gasaustrittsöffnungen, die in gleichmäßiger Flächenverteilung angeordnet sind. Durch die im Ausführungsbeispiel einen rechteckigen Grundriss aufweisende Gasaustrittsfläche 4' kann das Prozessgas während des Beschichtungsprozesses in die Prozesskammer 1 einströmen. Während des Maskenwechsels, des Substratwechsels oder in einem Ruhezustand kann durch die Gasaustrittsfläche 4' ein Inertgas in die Prozesskammer 1 strömen.

Mit der in der Figur 12 dargestellten Antriebsvorrichtung 25 kann die Schirmplatte 11 aus der in Figur 12 dargestellten Bevorratungsstellung in die in Figur 14 dargestellte Wirkstellung gebracht werden, in der die Schirmplatte 11 unterhalb der Gasaustrittsfläche 4' des Gaseinlassorganes 4 liegt.

Das Gaseinlassorgan wird mit einer nicht dargestellten Heizung auf Temperaturen zwischen 200° und 400° aufgeheizt. In anderen Prozessen kann das Gaseinlassorgan 4 aber auch auf höhere Prozesstemperaturen aufgeheizt werden. Die Schirmplatte 11 ist im Ausführungsbeispiel dreischichtig aufgebaut. Bei der zum Gaseinlassorgan 4 hin weisenden Platte 18 handelt es sich um eine 1 mmstarke Glasplatte. Zwischen dieser Glasplatte 18 und einer unteren Quarzglasplatte 20, die eine Dicke zwischen 8 mm und 10 mm aufweisen kann, liegt eine 100 µm-starke Folie aus einem hochreflektierenden Material, insbesondere einem Metall, insbesondere INVAR, Gold oder Aluminium. Wegen der verschiedenen thermischen Ausdehnungseigenschaften ist die Folie 19 schwimmend zwischen Glasplatte und Quarzglasplatte 20 gelagert. Die Emmissivität der Folie im Bereich der Wärmestrahlung ist geringer als 0,1.

Mit der Schirmplatte 11 wird die vom Gaseinlassorgan 4 abgestrahlte Wärmestrahlung in Richtung des Suszeptors 5 bzw. des dort angeordneten Substrates 12 abgeschirmt.

Der Suszeptor 5 besitzt eine Kühleinrichtung, mit der die Oberflächentemperatur des Suszeptors 5 auf Temperaturen zwischen -80° C und 20° C gekühlt werden kann. Indem das Substrat 12 auf einer gekühlten Oberfläche des Suszeptors 5 aufliegt, wird es auf einer gekühlten Temperatur gehalten.

Wie oben bereits ausgeführt, bildet die Schirmplatte 11 das Transportorgan aus, mit dem eine Maske 10,10', 10", 10'" aus dem Magazin 9 der Maskenbevorratungskammer 2 in die Prozesskammer 1 gebracht werden kann. Hierzu besitzen die Masken 10 bzw. in den Zeichnungen nicht dargestellte Maskenrahmen Gegenhalterungen, die mit in den Figuren 13 und 14 lediglich schematisch dargestellten Klemmorganen 17 der Schirmplatte 11 zusammenwirken können. Die Klemmorgane 17 sind so ausgerüstet, dass mit ihnen eine Maske 10 gegriffen und wieder freigegeben werden kann.

Die Funktionsweise der Vorrichtung ist die folgende:

Die Figur 1 zeigt die Vorrichtung in einer Ruhestellung, in der der Suszeptor 5 eine abgesenkte Position einnimmt, die Tore 8 der Beladeöffnungen 6, 7, 22 und 23 geschlossen sind, sich kein Substrat 12, keine Maske 10 und auch nicht die Schirmplatte 11 in der Prozesskammer 1 befindet. Der Totaldruck innerhalb der Prozesskammer kann zwischen 0,1 mbar und 2 mbar betragen. Die Prozesskammer 1 kann mit einem Inertgas gespült sein. Die Substratbevorratungskammer 3 und die Maskenbevorratungskammer 2 befinden sich auf demselben Totaldruck.

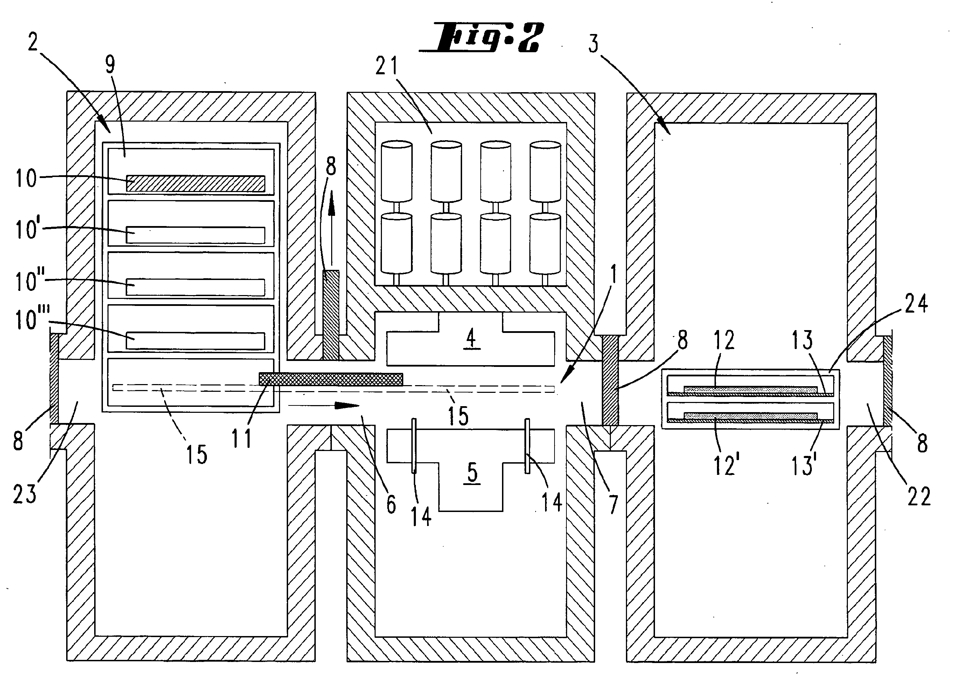

Die Figur 2 zeigt den ersten Schritt zur Beladung der Prozesskammer 1. Aus der untersten Etage des Magazins 9, die sich vor der Beladeöffnung 6 befindet, wird die Schirmplatte 11 mit Hilfe der Antriebsvorrichtung 25 über die Schienen 15 durch die geöffnete Beladeöffnung 6 hindurch in die Prozesskammer 1 verlagert.

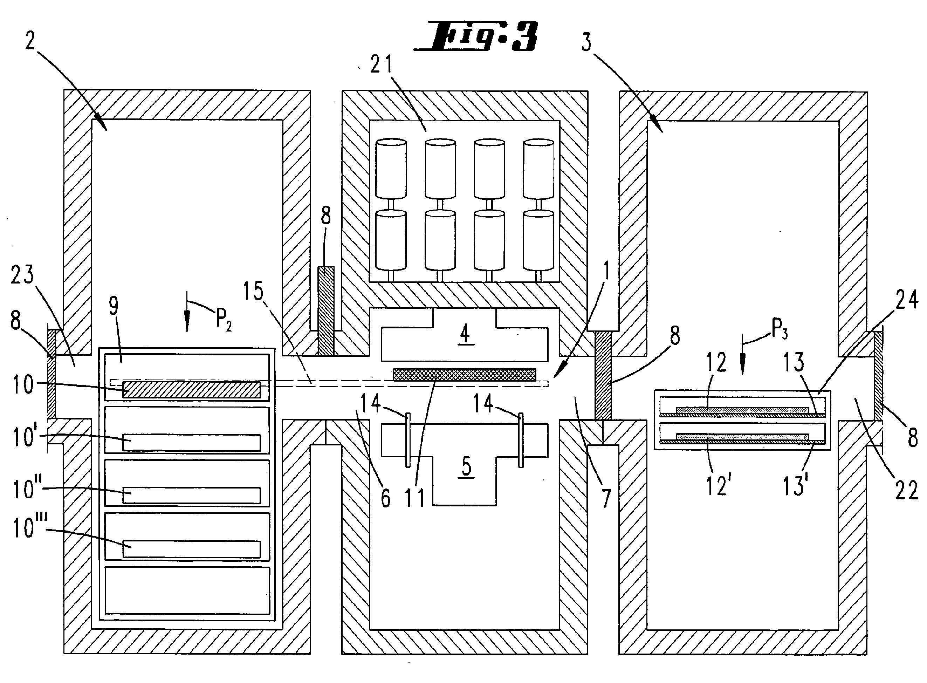

Einhergehend damit wird das Magazin 9 in Richtung des in der Figur 3 dargestellten Pfeiles P₂ abgesenkt. Das Magazin 24 wird ebenfalls in Richtung des Pfeiles P₃ in die in Figur 3 dargestellte Stellung abgesenkt. Die Schirmplatte 11 befindet sich in der in Figur 3 dargestellten Betriebsstellung unterhalb des Gaseinlassorganes 4.

In einem Folgeschritt fährt die Schirmplatte 11, angetrieben durch die Antriebsvorrichtung 25 auf den Schienen 15 durch die Beladeöffnung 6 zurück in die Maskenbevorratungskammer 2 und dort in eine Etage, in der sich eine Maske 10 befindet.

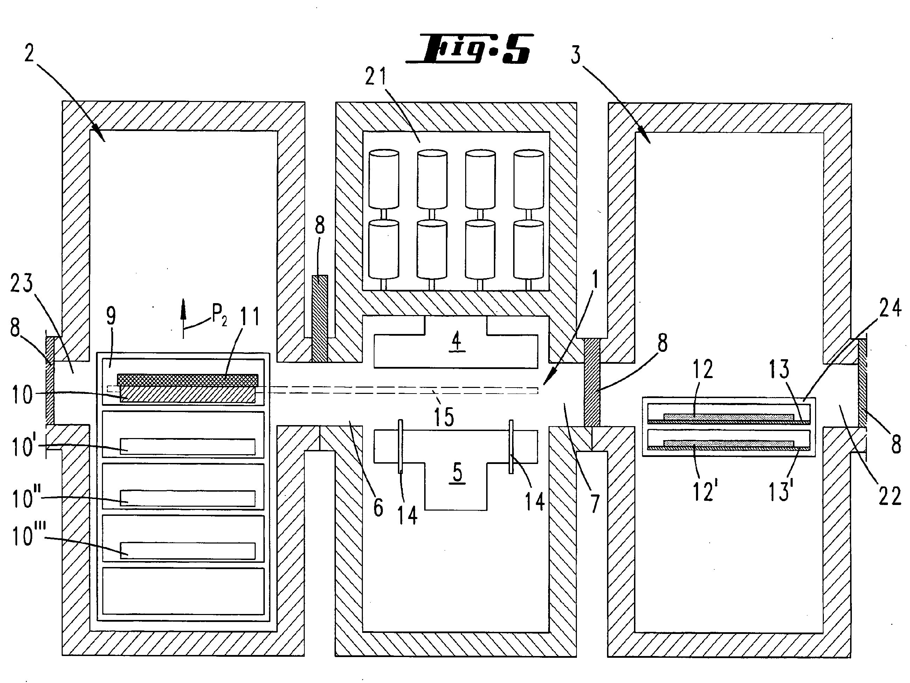

Die Schirmplatte 11 erreicht dann ihre in Figur 5 dargestellte Stellung, in der die Maske 10 mit den Klemmorganen 17 an der Unterseite der Schirmplatte 11 befestigt wird.

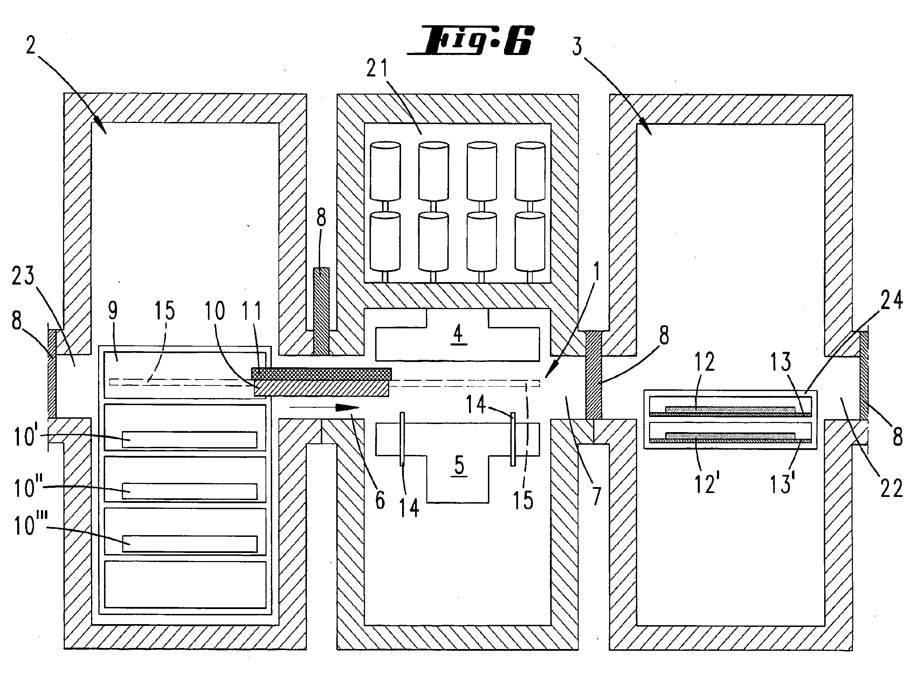

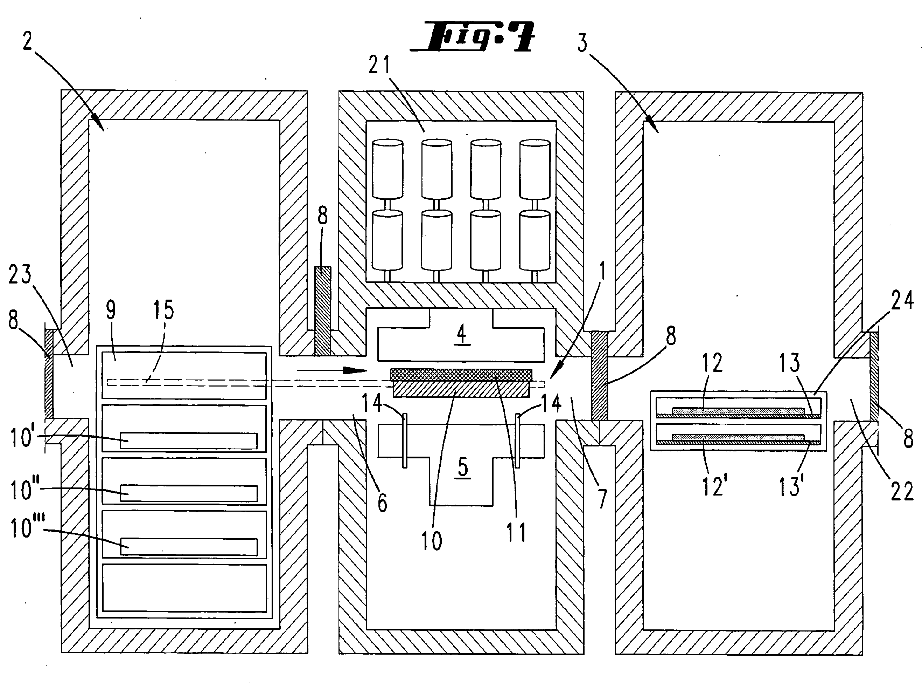

Die Figur 6 zeigt, wie die Schirmplatte 11 die an ihrer Unterseite befestigte Maske 10 durch die Beladeöffnung 6 in die Prozesskammer 1 bis in die in Figur 7 dargestellte Stellung transportiert, in der die Schirmplatte 11 und die von ihr getragene Maske 10 unterhalb des Gaseinlassorganes 4 liegen. Die vom Gaseinlassorgan 4 abgestrahlte Wärme wird jetzt gegenüber dem Suszeptor 5 abgeschirmt.

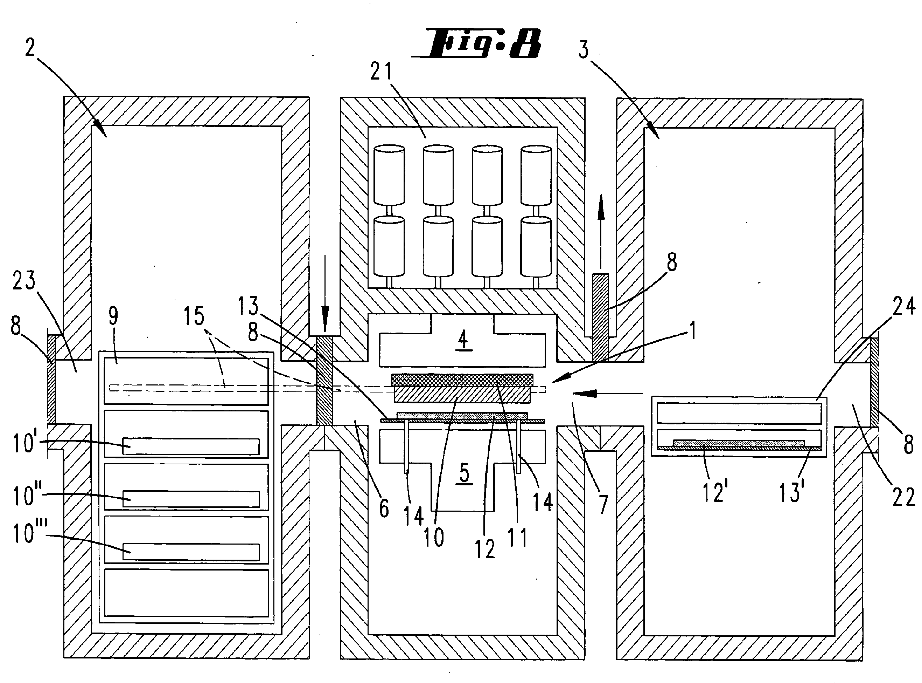

Die Figur 8 zeigt den darauffolgenden Schritt, bei dem nach Öffnen der Beladeöffnung 7 mittels der Fördereinrichtung 13 ein Substrat 12 in die Prozesskammer 1 eingebracht wird. Das Substrat 12 wird auf den Stützstiften 14 abgesetzt, so dass es eine Abstandslage zur Oberseite des Suszeptors 5 besitzt. Anschlie-βend wird die Fördereinrichtung 13, bei der es sich im Ausführungsbeispiel um einen Substrathalter handelt, zurück in das Magazin 24 verlagert und die Beladeöffnung 7 durch Schließen des Tores 8 verschlossen.

Anschließend wird der Suszeptor 5 in Richtung des Pfeiles P₁ in der Figur 10 nach oben gefahren, bis auf ihm das Substrat 12 aufliegt.

Schließlich wird die Schirmplatte 11 aus der Prozesskammer 1 in die Bevorratungskammer 2 verlagert, so dass die in Figur 11 dargestellte Prozessstellung erreicht ist. In dieser Prozessstellung werden bei einem Totaldruck zwischen 0,1 mbar und 2 mbar in der Gasversorgungseinrichtung 21 gemischte oder erzeugte Prozessgase durch das Gaseinlassorgan 4 in die Prozesskammer 1 eingeleitet. Die Prozessgase können innerhalb der Prozesskammer 1, beispielsweise auf der Substratoberfläche des Substrates 12 chemisch reagieren, um dort eine Schicht abzuscheiden. Bei der Maske 10 handelt es sich um eine Schattenmaske, so dass das Wachstum nur an den Stellen stattfindet, die nicht abgeschattet werden.

Die Gasversorgungseinrichtung 21 ist insbesondere in der Lage, das Gaseinlassorgan 4 mit einem Monomer zu versorgen, das mittels eines Trägergases transportiert wird. Dieses Monomer hat die Eigenschaften, bei tiefen Temperaturen zu kondensieren. Trifft es auf die gekühlte Substratoberfläche des Substrates 12, so kondensiert es dort bzw. polymerisiert zu einem Polymer.

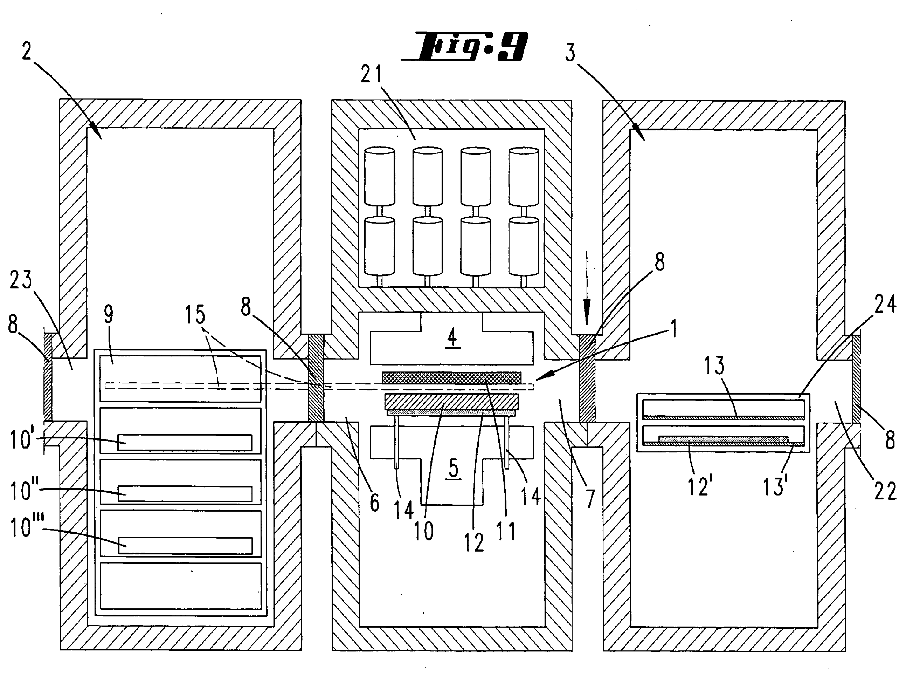

Ohne Abkühlen des Gaseinlassorganes wird nach Beendigung des Beschichtungsprozesses die Schirmplatte 11 von der in Figur 11 dargestellten Prozessstellung in die in Figur 10 dargestellte Stellung gebracht. Der Suszeptor 5 wird in die in Figur 9 dargestellte Stellung abgesenkt. Die Maske 10 wird mit Hilfe der Schirmplatte 11 von der Substratoberfläche des Substrates 12 abgehoben bzw. durch Absenken der Stützstifte 14 wird das Substrat 12 von der Maske 10 entfernt. Anschließend wird das Substrat 12 mit Hilfe eines Substrathalters 13 aus der Prozesskammer zurück in das Magazin 24 gefördert.

Es kann dann ein weiteres Substrat 12' mit Hilfe eines Substrathalters 13' in die Prozesskammer 1 gebracht werden, um in der zuvor beschriebenen Weise beschichtet zu werden.

Die Vorrichtung eignet sich auch zum Abscheiden von OLEDs oder Halbleitschichten, beispielsweise mit dem MOCVD-Verfahren.

**Bezugszeichenliste:**

| | | | |
|---|---|---|---|
| 1 | Prozesskammer | P | Pfeil |
| 2 | Maskenbevorratungskammer | P₁ | Pfeil |
| 3 | Substratbevorratungskammer | P₂ | Pfeil |
| 4 | Gaseinlassorgan | P₃ | Pfeil |
| 5 | Suszeptor | | |
| 6 | Beladeöffnung | | |
| 7 | Beladeöffnung | | |
| 8 | Tor | | |
| 9 | Magazin | | |
| 10 | Maske | | |
| 11 | Schirmplatte | | |
| 12 | Substrat | | |
| 13 | Substrathalterung, -fördereinrichtung | | |
| 14 | Stützstift | | |
| 15 | Schiene | | |
| 16 | Rollenführung | | |
| 17 | Klemmorgan | | |
| 18 | Quarzglasplatte | | |
| 19 | Reflektionsfolie | | |
| 20 | Quarzglasplatte | | |
| 21 | Gasversorgungseinrichtung | | |
| 22 | Beladeöffnung | | |
| 23 | Beladeöffnung | | |
| 24 | Magazin | | |
| 25 | Antriebsvorrichtung | | |

## Patentansprüche

1. Vorrichtung zum Behandeln, insbesondere Beschichten eines Substrates (12) mit einer Prozesskammer (1), mit mindestens einer mit der Prozesskammer (1) über eine Beladeöffnung (6, 7) verbundenen Bevorratungskammer (2,3) zur Bevorratung in der Prozesskammer (1) zu behandelnder Substrate (12) bzw. bei der Behandlung zu verwendenden Masken (10, 10', 10", 10"'), mit einer Fördereinrichtung (13) zum Be- und Entladen der Prozesskammer (1) durch die Beladeöffnung (6,7) mit Substraten bzw. Masken (10,10', 10", 10"'), mit einem temperierbaren Gaseinlassorgan (4) zum Einleiten eines Ausgangsstoffes zusammen mit einem Trägergas in die Prozesskammer (1), einem dem Gaseinlassorgan (4) gegenüberliegenden Suszeptor (5) zur Aufnahme eines zu behandelnden Substrates (12), mit einer Schirmplatte (11), die in einer Abschirmstellung zwischen Gaseinlassorgan (4) und Suszeptor (5) bzw. einer Maske (10) liegt, um das Substrat (12) bzw. die Maske (10) gegen eine Temperaturbeeinflussung vom Gaseinlassorgan (4) abzuschirmen, mit einer Schirmplattenverlagerungseinrichtung (15,16), um die Schirmplatte (11) vor dem Behandeln des Substrates (12) aus der Abschirmstellung vor dem Gaseinlassorgan (4) in einer Bevorratungsstellung zu verlagern und nach dem Behandeln des Substrates (12) die Schirmplatte (11) aus der Bevorratungsstellung zurück in die Abschirmstellung zu verlagern, **dadurch gekennzeichnet, dass** sich die Schirmplatte (11) in der Bevorratungsstellung innerhalb einer der Bevorratungskammern (2, 3) befindet.

2. Vorrichtung nach Anspruch 1, **gekennzeichnet durch** eine erste Bevorratungskammer (3) zur Bevorratung mindestens eines Substrates (12) und eine zweite Bevorratungskammer (2), in welcher die Schirmplatte (11) während des Behandlungsprozesses Aufnahme findet.

3. Vorrichtung nach Anspruch 2, **dadurch gekennzeichnet, dass** die zweite Bevorratungskammer eine Maskenbevorratungskammer (2) zur Bevorratung mindestens einer Maske (10,10', 10", 10"') ist, die mit Hilfe der Schirmplattenverlagerungseinrichtung (15,16) bzw. mit Hilfe der Schirmplatte (11) aus der Maskenbevorratungskammer (2) in die Prozesskammer (1) bringbar ist.

4. Vorrichtung nach einem der vorangehenden Ansprüche, **dadurch gekennzeichnet, dass** die zum Gaseinlassorgan (4) und/ oder zum Suszeptor bzw. zur Maske (10) weisende Oberfläche der Schirmplatte (11) hochreflektierend ist.

5. Vorrichtung nach einem der vorangehenden Ansprüche, **dadurch gekennzeichnet, dass** die Schirmplatte (11) eine zwischen zwei Glas- oder Quarzplatten (18, 20) angeordnete hoch reflektierende Folie (19) aufweist.

6. Vorrichtung nach einem der vorangehenden Ansprüche, **dadurch gekennzeichnet, dass** die Maskenbevorratungskammer (2) ein insbesondere in Vertikalrichtung verlagerbares Magazin (9) aufweist zur Aufnahme der Schirmplatte (11) und mindestens einer Maske (10).

7. Vorrichtung nach einem der vorangehenden Ansprüche, **dadurch gekennzeichnet, dass** die Schirmplattenverlagerungseinrichtung (15,16) eine in der Maskenbevorratungskammer (2) angeordnete Antriebseinrichtung (25) und eine sich bis in die Prozesskammer (1) erstreckende Schienenanordnung (15) aufweist.

8. Vorrichtung nach einem der vorangehenden Ansprüche, **dadurch gekennzeichnet, dass** eine die Prozesskammer (1) mit der Maskenbevorratungskammer (2) verbindende Beladeöffnung (6) der die Prozesskammer (1) mit der Substratbevorratungskammer (3) verbindenden Beladeöffnung (7) gegenüberliegt.

9. Vorrichtung nach einem der vorangehenden Ansprüche, **gekennzeichnet durch** vom Suszeptor (5) in Richtung auf das Gaseinlassorgan (4) abragende Stützstifte (14) zur Ablage des Substrates (12) mittels einer insbesondere gabelförmigen Substratfördereinrichtung (13), wobei der Suszeptor (5) höhenverlagerbar ist, um ihn **durch** eine Aufwärtsverlagerung in einen wärmeleitenden Kontakt zum Substrat (12) zu bringen.

10. Verfahren zum Behandeln, insbesondere Beschichten eines Substrates (12) in einer Prozesskammer (1), wobei eine Schirmplatte (11) mit Hilfe einer Schirmplattenverlagerungseinrichtung (15,16) zwischen ein temperiertes Gaseinlassorgan zum Einleiten eines Ausgangsstoffs zusammen mit einem Trägergas und einem Suszeptor (5) zur Aufnahme des Substrates (12) in eine Abschirmstellung gebracht wird, danach das Substrat (12) in der Abschirmstellung mit Hilfe einer Fördereinrichtung (13) in die Prozesskammer (1) gebracht und auf dem Suszeptor (5) abgelegt wird, danach die Schirmplatte (11) von der Abschirmstellung in eine Bevorratungsstellung gebracht wird, danach durch Einleiten des gasförmigen Ausgangsstoffes durch das temperierte Gaseinlassorgan (4) das Substrat (12) behandelt, insbesondere eine Schicht auf dem Substrat (12) abgeschieden wird, danach die Schirmplatte (11) mit Hilfe der Schirmplattenverlagerungseinrichtung (15,16) aus der Bevorratungsstellung zurück in die Abschirmstellung gebracht wird und schließlich das Substrat (12) mit Hilfe der Fördereinrichtung (13) aus der Prozesskammer (1) in eine Bevorratungskammer (3) gebracht wird, **dadurch gekennzeichnet, dass** sich die Schirmplatte (11) in der Bevorratungsstellung in der Bevorratungskammer (2,3) befindet.

11. Verfahren nach Anspruch 10, **dadurch gekennzeichnet, dass** sich die Maske in der Bevorratungsstellung in einer Maskenbevorratungskammer (2) befindet und durch die Beladeöffnung (6) in die Abschirmstellung gebracht wird.

12. Verfahren nach einem der Ansprüche 10 bis 11, **dadurch gekennzeichnet, dass** eine Maske (10) aus einer Maskenbevorratungskammer (2) mit Hilfe der Schirmplattenverlagerungseinrichtung (15,16) bzw. mit Hilfe der Schirmplatte (11) in die Prozesskammer (1) gebracht wird.

## Claims

1. Device for treating, in particular coating, a substrate (12), having a process chamber (1), at least one storage chamber (2, 3) for storing substrates (12) to be treated in the process chamber (1), which is connected to the process chamber (1) via a loading opening (6, 7), or for storing masks (10, 10', 10", 10"') to be used in the treating process, having a conveying device (13) for loading and unloading substrates or masks (10, 10', 10", 10"') into and from the process chamber (1) through the loading opening (6,7), having a temperature-controllable gas inlet element (4) for introducing a starting material together with a carrier gas into the process chamber (1), a susceptor (5) situated opposite from the gas inlet element (4) for receiving a substrate (12) to be treated, having a shielding plate (11) which, in a shielding position, is situated between the gas inlet element (4) and the susceptor (5) or a mask (10) in order to shield the substrate (12) or the mask (10) from the influence of heat from the gas inlet element (4), having a shielding plate displacement device (15, 16) in order to displace the shielding plate (11), before the substrate (12) is treated, from the shielding position in front of the gas inlet element (4) into a storage position and, after the substrate (12) is treated, to displace the shielding plate (11) from the storage position back into the shielding position, **characterized in that**, in the storage position, the shielding plate (11) is situated inside one of the storage chambers (2, 3).

2. Device according to Claim 1, **characterized by** a first storage chamber (3) for storing at least one substrate (12), and a second storage chamber (2) in which the shielding plate (11) is accommodated during the treatment process.

3. Device according to claim 2, **characterized in that** the second storage chamber is a mask storage chamber (2) for storing at least one mask (10, 10', 10", 10"'), which may be brought from the mask storage chamber (2) into the process chamber (1) with the aid of the shielding plate displacement device (15, 16) or with the aid of the shielding plate (11).

4. Device according to one of the preceding claims, **characterized in that** the surface of the shielding plate (11) facing the gas inlet element (4) and/or facing the susceptor or the mask (10) is highly reflective.

5. Device according to one of the preceding claims, **characterized in that** the shielding plate (11) has a highly reflective foil (19) situated between two glass or quartz plates (18, 20).

6. Device according to one or more of the preceding claims or in particular according thereto, **characterized in that** the mask storage chamber (2) has a magazine (9), which is displaceable in particular in the vertical direction, for accommodating the shielding plate (11) and at least one mask (10).

7. Device according to one of the preceding claims, **characterized in that** the shielding plate displacement device (15, 16) has a drive device (25) situated in the mask storage chamber (2), and a rail arrangement (15) which extends into the process chamber (1).

8. Device according to one of the preceding claims, **characterized in that** a loading opening (6) in the process chamber (1) which connects the process chamber (1) to the mask storage chamber (2) is situated opposite from the loading opening (7) which connects the process chamber (1) to the substrate storage chamber (3).

9. Device according to one of the preceding claims, **characterized by** support pins (14) which protrude from the susceptor (5) in the direction of the gas inlet element (4) for set-down of the substrate (12) using a substrate conveying device (13) which in particular is fork-shaped, the susceptor (5) being vertically displaceable in order to bring it into heat-conductive contact with the substrate (12) by means of an upward movement.

10. Method for treating, in particular coating, a substrate (12), having a process chamber (1), a shielding plate (11) being brought, with the aid of a shielding plate displacement device (15, 16), into a shielding position between a temperature-controlled gas inlet element for introducing a starting material together with a carrier gas, and a susceptor (5) for receiving the substrate (12), and subsequently the substrate (12) in the shielding position is brought into the process chamber (1) with the aid of a conveying device (13) and set down on the susceptor (5), and subsequently the shielding plate (11) is brought from the shielding position into a storage position, and subsequently the substrate (12) is treated, in particular a layer being deposited on the substrate (12), by introducing the gaseous starting material via the temperature-controlled gas inlet element (4), and subsequently the shielding plate (11) is brought from the storage position back into the shielding position using the shielding plate displacement device (15, 16), and lastly, the substrate (12)) is brought from the process chamber (1) into a storage chamber (3) with the aid of the conveying device (13), **characterized in that**, in the storage position, the shielding plate (11) is in the storage chamber (2, 3).

11. Method according to Claim 10, **characterized in that** the mask in the storage position is in a mask storage chamber (2), and is brought into the shielding position through the loading opening (6).

12. Method according to one of Claims 10 to 11 or in particular according thereto, **characterized in that** a mask (10) is brought from a mask storage chamber (2) into the process chamber (1) using the shielding plate displacement device (15, 16) or with the aid of the shielding plate (11).

## Revendications

1. Dispositif de traitement, notamment de revêtement, d'un substrat (12), ledit dispositif comportant une chambre de réaction (1), une chambre de stockage (2, 3) reliée à la chambre de réaction (1) par un orifice de chargement (6, 7) et destinée à stocker des substrats (12) devant être traités dans la chambre de réaction (1) ou des masques (10, 10', 10", 10''') devant être utilisés lors du traitement, un mécanisme de transport (13) destiné à charger et décharger des substrats ou des masques (10, 10', 10", 10''') dans la chambre de réaction (1) par l'orifice de chargement (6, 7), un organe d'admission de gaz (4) pouvant être régulé en température et destiné à introduire une substances de départ, conjointement avec un gaz porteur, dans la chambre de réaction (1), un suscepteur (5) opposé à l'organe d'admission de gaz (4) et destiné à recevoir un substrat (12) à traiter, une plaque de protection (11) qui est placée dans une position de protection entre l'organe d'admission de gaz (4) et le suscepteur (5) ou un masque (10) afin de protéger le substrat (12) ou le masque (10) de l'influence de la température de l'organe d'admission de gaz (4), un mécanisme de déplacement de plaque de protection (15, 16) destiné à déplacer la plaque de protection (11), avant le traitement du substrat (12), de la position de protection devant l'organe d'admission de gaz (4) dans une position de stockage et de ramener, après le traitement du substrat (12), la plaque de protection (11) de la position de stockage dans la position de protection, **caractérisé en ce que** la plaque de protection (11) se trouve dans la position de stockage à l'intérieur de l'une des chambres de stockage (2, 3).

2. Dispositif selon la revendication 1, **caractérisé par** une première chambre de stockage (3) destinée à stocker au moins un substrat (12) et une seconde chambre de stockage (2) dans laquelle la plaque de protection (11) est logée au cours du processus de traitement.

3. Dispositif selon la revendication 2, **caractérisé en ce que** la seconde chambre de stockage est une chambre de stockage de masques (2) destiné à stocker au moins un masque (10, 10', 10", 10''') qui peut être amené de la chambre de stockage de masques (2) dans la chambre de réaction (1) à l'aide du mécanisme de déplacement de plaque de protection (15, 16) ou à l'aide de la plaque de protection (11).

4. Dispositif selon l'une des revendications précédentes, **caractérisé en ce que** la surface de la plaque de protection (11) qui est dirigée vers l'organe d'admission de gaz (4) et/ou vers le suscepteur ou le masque (10) est hautement réfléchissante.

5. Dispositif selon l'une des revendications précédentes, **caractérisé en ce que** la plaque de protection (11) comporte un film (19) hautement réfléchissant disposé entre deux plaques de verre ou de quartz (18, 20).

6. Dispositif selon l'une des revendications précédentes, **caractérisé en ce que** la chambre de stockage de masques (2) comporte un magasin (9) déplaçable notamment en direction verticale et destiné à recevoir la plaque de stockage (11) et au moins un masque (10).

7. Dispositif selon l'une des revendications précédentes, **caractérisé en ce que** le mécanisme de déplacement de plaque de protection (15, 16) comporte un mécanisme d'entraînement (25) disposé dans la chambre de stockage de masques (2) et un ensemble de rails (15) s'étendant jusque dans la chambre de réaction (1).

8. Dispositif selon l'une quelconque des revendications précédentes, **caractérisé en ce qu'**un orifice de chargement (6) reliant la chambre de réaction (1) à la chambre de stockage de masques (2) est placée en face de l'orifice de chargement (7) reliant la chambre de réaction (1) à la chambre de stockage de substrat (3).

9. Dispositif selon l'une des revendications précédentes, **caractérisé par** des broches de support (14) faisant saillie du suscepteur (5) dans la direction de l'organe d'admission de gaz (4) et destiné à supporter ledit substrat (12) au moyen d'un mécanisme de transport de substrat notamment en forme de fourche (13), le suscepteur (5) étant déplaçable en hauteur afin de l'amener en contact de conduction thermique avec le substrat (12) en le déplaçant vers le haut.

10. Procédé de traitement, notamment de revêtement, d'un substrat (12) dans une chambre de réaction (1), dans lequel une plaque de protection (11) est amenée dans une position de protection à l'aide d'un mécanisme de déplacement de plaque de protection (15, 16) entre un organe d'admission de gaz, régulé en température, destiné à introduire une substance de départ conjointement avec un gaz porteur et un suscepteur (5) destiné à recevoir le substrat (12), puis le substrat (12) est amené dans la position de protection dans la chambre de réaction (1) à l'aide d'un mécanisme de transport (13) et est déposé sur le suscepteur (5), ensuite la plaque de protection (11) est amenée de la position de protection dans une position de stockage, après quoi le substrat (12) est traité, notamment une couche est déposée sur le substrat (12), par introduction de la substance gazeuse de départ à travers l'organe d'admission de gaz (4) régulé en température, puis la plaque de protection (11) est ramenée à l'aide du mécanisme de transport de plaque de protection (15, 16) de la position de stockage dans la position de protection, et enfin le substrat (12) est amené à l'aide du mécanisme de transport (13) de la chambre de réaction (1) dans une chambre de stockage (3), **caractérisé en ce que** la plaque de protection (11) se trouve dans la position de stockage dans la chambre de stockage (2, 3).

11. Procédé selon la revendication 10, **caractérisé en ce que** le masque se trouve dans la position de stockage dans une chambre de stockage de masques (2) et est amené dans la position de protection par l'orifice de chargement (6).

12. Procédé selon l'une quelconque des revendications 10 à 11, **caractérisé en ce qu'**un masque (10) est amené d'une chambre de stockage de masques (2) dans la chambre de réaction (1) à l'aide du mécanisme de déplacement de plaque de protection (15, 16) ou à l'aide de la plaque de protection (11).
